(19) Europäisches Patentamt
European Patent Office
Office européen des brevets

(11) **EP 1 744 375 B1**

(12) **EUROPÄISCHE PATENTSCHRIFT**

(45) Veröffentlichungstag und Bekanntmachung des Hinweises auf die Patenterteilung:
**30.10.2019 Patentblatt 2019/44**

(51) Int Cl.:
*H01L 33/20* (2010.01)   *H01L 33/46* (2010.01)
*H01L 33/00* (2010.01)

(21) Anmeldenummer: **06013665.2**

(22) Anmeldetag: **30.06.2006**

(54) **Optoelektronischer Chip und Herstellungsverfahren dafür**

Optoelectronic chip and process for its manufacture

Puce opto-électronique et procédé de sa réalisation

(84) Benannte Vertragsstaaten:
**DE**

(30) Priorität: **14.07.2005 DE 102005033005**

(43) Veröffentlichungstag der Anmeldung:
**17.01.2007 Patentblatt 2007/03**

(73) Patentinhaber: **OSRAM Opto Semiconductors GmbH**
**93055 Regensburg (DE)**

(72) Erfinder:
• **Wirth, Ralph**
**93186 Pettendorf-Adlersberg (DE)**

• **Streubel, Klaus**
**93164 Laaber (DE)**

(74) Vertreter: **Epping - Hermann - Fischer**
**Patentanwaltsgesellschaft mbH**
**Schloßschmidstraße 5**
**80639 München (DE)**

(56) Entgegenhaltungen:
WO-A2-02/071104   DE-A1- 2 543 471
GB-A- 1 195 547   GB-A- 2 145 281
JP-A- 3 085 774   JP-A- 55 162 284
US-A1- 2005 056 856   US-B1- 6 252 219

**Beschreibung**

Es wird ein optoelektronischer Chip angegeben. Darüber hinaus wird ein Verfahren zur Herstellung eines solchen Chips angegeben.

Die Druckschrift WO 02/13281A1 beschreibt einen lichtemittierenden Halbleiterchip und ein Verfahren zu dessen Herstellung.

Die Druckschrift JP-A-55162284 beschreibt eine Leuchtdiode sowie ein Verfahren zur Herstellung einer Leuchtdiode.

Die Druckschrift US-A-2005/0056856 beschreibt einen Laser sowie ein Verfahren zur Herstellung eines Lasers.

Die Druckschrift DE-A-25 43 471 beschreibt eine Leuchtdioden-Anordnung mit einer gewölbten Struktur.

Eine zu lösende Aufgabe besteht darin, einen optoelektronischen Chip mit besonders hoher Strahlungsauskoppeleffizienz anzugeben. Eine weitere Aufgabe besteht darin einen optoelektronischen Chip anzugeben, bei dem ein besonders großer Anteil der erzeugten elektromagnetischen Strahlung in einen bestimmten Raumwinkelbereich ausgekoppelt wird.

Die Erfindung betrifft einen optoelektronischen Chip gemäß Anspruch 1 sowie ein Verfahren zur Herstellung eines optoelektronischen Chips gemäß Anspruch 14.

Der optoelektronische Chip weist einen Halbleiterkörper auf. Der Halbleiterkörper umfasst beispielsweise eine auf ein Aufwachssubstrat abgeschiedene epitaktische Halbleiterschichtenfolge. Bevorzugt umfasst die Schichtenfolge eine aktive Zone, die geeignet ist, elektromagnetische Strahlung zu erzeugen. Die aktive Zone kann beispielsweise durch eine oder mehrere Schichten der Halbleiterschichtenfolge gegeben sein. Bevorzugt umfasst die aktive Zone einen pn-Übergang, eine Doppelheterostruktur, eine Einfachquantentopfstruktur oder eine Mehrfachquantentopfstruktur.

Vorzugsweise ist das Aufwachssubstrat gedünnt oder vollständig vom Halbleiterkörper entfernt. Bei dem Halbleiterkörper handelt es sich dann um eine so genannte Dünnfilmschicht.

Gemäß zumindest einer Ausführungsform des optoelektronischen Chips weist die aktive Zone einen strahlungsemittierenden Bereich auf. Der strahlungsemittierende Bereich ist zum Beispiel durch einen Teil der aktiven Zone gebildet. Nur in diesem Teilbereich der aktiven Zone wird im Betrieb des optoelektronischen Chips elektromagnetische Strahlung erzeugt. Der strahlungsemittierende Bereich ist beispielsweise dadurch erzeugt, dass die aktive Zone abgesehen vom strahlungsemittierenden Bereich derart geschädigt ist, dass nur mehr der strahlungsemittierende Bereich geeignet ist, im Betrieb des optoelektronischen Chips elektromagnetische Strahlung zu erzeugen. Es ist aber auch möglich, dass der Halbleiterkörper derart ausgebildet ist, dass im Betrieb lediglich der strahlungsemittierende Bereich bestromt wird und daher nur in diesem Bereich der aktiven Zone Strahlungserzeugung stattfindet. Auch eine Kombination beider Maßnahmen - das heißt, Schädigung der aktiven Zone bis auf den strahlungsemittierenden Bereich und Bestromung lediglich des strahlungsemittierenden Bereichs - ist möglich.

Der Halbleiterkörper weist einen Teilbereich auf, in dem die Oberfläche des Halbleiterkörpers konvex zu einem Träger hin gekrümmt ist. Das heißt, zumindest in einem Teilbereich des Halbleiterkörpers weist die Oberfläche des Halbleiterkörpers eine konvexe Wölbung auf. Dieser Teilbereich ist beispielsweise in die Oberfläche des Halbleiterkörpers strukturiert. Das heißt, der Teilbereich ist in den epitaktisch gewachsenen Halbleiterkörper strukturiert. Dazu kann zum Beispiel eine Ätztechnik Verwendung finden. Die Oberfläche des Halbleiterkörpers, die den konvexen Teilbereich aufweist, ist einem Träger zugewandt. Der Halbleiterkörper ist an dieser Oberfläche beispielsweise mechanisch fest mit dem Träger verbunden. Bevorzugt handelt es sich bei der Oberfläche, die den konvex zum Träger hin gekrümmten Teilbereich aufweist, um die dem Aufwachssubstrat ursprünglich abgewandte Oberfläche des Halbleiterkörpers.

Der Träger kann verglichen mit dem Aufwachssubstrat relativ frei gewählt sein. So kann der Träger hinsichtlich mancher Eigenschaften wie etwa Leitfähigkeit oder mechanischer Stabilität für den Chip besser geeignet sein, als verfügbare Aufwachssubstrate, die zur Herstellung hochwertiger epitaktischer Schichten engen Einschränkungen unterliegen. So muss, um hochwertige epitaktische Schichten zu erhalten, das epitaktisch abgeschiedene Material beispielsweise gitterangepasst zum Aufwachssubstrat sein.

Bevorzugt zeichnet sich der Träger durch einen an den Halbleiterkörper angepassten thermischen Ausdehnungskoeffizienten aus. Beispielsweise kann der Träger ein Halbleitermaterial wie Germanium, Galliumarsenid, Galliumnitrid, Siliziumkarbid und andere Materialien wie Saphir, Molybdän, Metalle oder Karbon enthalten. Ferner zeichnet sich der Träger bevorzugt durch eine besonders gute thermische Leitfähigkeit aus, sodass die bei der Erzeugung von elektromagnetischer Strahlung in der aktiven Zone des Halbleiterkörpers entstehende Wärme zumindest teilweise über den Träger an die Umgebung abgegeben werden kann.

Der strahlungsemittierende Bereich weist eine kleinere laterale Ausdehnung auf als der konvex gekrümmte Teilbereich. Unter lateraler Ausdehnung des strahlungsemittierenden Bereichs ist dabei die maximale Erstreckung des strahlungsemittierenden Bereichs in einer Ebene des Halbleiterkörpers zu verstehen, die senkrecht oder im Wesentlichen senkrecht zur Wachstumsrichtung des Halbleiterkörpers verläuft. Beispielsweise verläuft diese Ebene parallel zur Oberfläche des Trägers, die dem Halbleiterkörper zugewandt ist. Die laterale Ausdehnung des konvex gekrümmten Teilbereichs bezeichnet entsprechend die maximale Erstreckung des Teilbereichs in einer Ebene, die senkrecht oder im Wesentlichen senkrecht zur Wachstumsrichtung des Halbleiterkörpers verläuft. Bevorzugt ist die laterale Ausdehnung des konvex gekrümmten Teilbereichs wenigstens doppelt so groß wie die laterale Ausdehnung des strahlungsemittierenden Bereichs, besonders bevorzugt wenigstens dreimal so groß.

Der Chip weist einen Halbleiterkörper mit einem strahlungsemittierenden Bereich und einem Teilbereich auf, in dem die Oberfläche des Halbleiterkörpers konvex zu einem Träger hin gekrümmt ist, wobei die laterale Ausdehnung des strahlungsemittierenden Bereichs kleiner ist, als die laterale Ausdehnung des Teilbereichs.

Gemäß zumindest einer Ausführungsform des optoelektronischen Chips ist zwischen Halbleiterkörper und Träger zumindest eine reflektierende Schicht angeordnet. Die reflektierende Schicht kann zum Beispiel einen Bragg-Spiegel oder eine metallhaltige Spiegelschicht umfassen. Eine metallhaltige reflektierende Schicht oder Schichtenfolge, die beispielsweise Gold, Goldgermanium, Silber, Aluminium oder Platin enthalten kann, zeichnet sich gegenüber einem Bragg-Spiegel durch eine geringere Richtungsabhängigkeit der Reflektivität aus. Auch lässt sich mit metallhaltigen Spiegeln eine höhere Reflektivität als mit Bragg-Spiegel erreichen. Weiter ist es möglich, dass die reflektierende Schichtenfolge eine reflektierende Metallschicht oder Schichtenfolge und eine Schicht umfasst, die ein dielektrisches Material enthält.

Besonders bevorzugt ist die zwischen Träger und Halbleiterkörper angeordnete reflektierende Schicht oder Schichtenfolge geeignet, die im Betrieb des optoelektronischen Chips vom strahlungsemittierenden Bereich erzeugte elektromagnetische Strahlung zu reflektieren.

Gemäß zumindest einer Ausführungsform des optoelektronischen Chips bedeckt die reflektierende Schicht den konvex gekrümmten Teilbereich zumindest stellenweise. Das heißt, die Oberfläche des Halbleiterkörpers ist zumindest dort, wo sich der konvex gekrümmte Teilbereich befindet, zumindest stellenweise mit der reflektierenden Schicht oder Schichtenfolge bedeckt.

Der beschriebene optoelektronische Chip macht sich dabei unter anderem die Idee zunutze, dass der mit einer reflektierenden Schicht bedeckte, konvex gekrümmte Teilbereich als Spiegel für die im strahlungsemittierenden Bereich erzeugte Strahlung fungiert. Mithilfe der Formgebung des Teilbereichs ist beispielsweise die Abstrahlcharakteristik der reflektierten Strahlung und damit die Abstrahlcharakteristik des Chips definiert einstellbar.

Beispielsweise kann so die Richtung, in die die Strahlung reflektiert wird, eingestellt werden.

Gemäß zumindest einer Ausführungsform weist der Halbleiterkörper eine Vielzahl strahlungsemittierender Bereiche auf. Das heißt, mehrere Bereiche der aktiven Zone des Halbleiterkörpers sind geeignet, im Betrieb des optoelektronischen Chips elektromagnetische Strahlung zu erzeugen. Die strahlungsemittierenden Bereiche können beispielsweise in einem regelmäßigen Muster mit im Wesentlichen gleichen Abständen voneinander in der aktiven Zone angeordnet sein. Bevorzugt sind in diesem Fall alle strahlungsemittierende Bereiche im Wesentlichen gleich groß, das heißt, alle strahlungsemittierenden Bereiche weisen beispielsweise im Wesentlichen die gleiche laterale Ausdehnung auf.

Im Wesentlichen gleiche laterale Ausdehnung bedeutet dabei, dass herstellungsbedingt oder aufgrund von ungewollten Inhomogenitäten im Halbleiterkörper Schwankungen in Ausdehnung und Anordnung der strahlungsemittierende Bereiche möglich sind.

Beispielsweise können die strahlungsemittierenden Bereiche durch Schädigung der aktiven Zone erzeugt sein, sodass nur solche Bereiche der aktiven Zone in Betrieb des optoelektronischen Chips geeignet sind, Strahlung zu erzeugen, die nicht geschädigt sind.

Gemäß zumindest einer Ausführungsform des optoelektronischen Chips, ist jedem strahlungsemittierenden Bereich ein konvex gekrümmter Teilbereich des Halbleiterkörpers zugeordnet. Zugeordnet heißt, dass im strahlungsemittierenden Bereich erzeugte elektromagnetische Strahlung größtenteils auf die konvex gekrümmte Oberfläche des Halbleiterkörpers im zugeordneten Teilbereich trifft und kaum oder gar keine Strahlung dieses strahlungserzeugenden Bereichs auf die Oberfläche anderer, beispielsweise benachbarter Teilbereiche trifft. Dabei ist es möglich, dass mehreren strahlungsemittierenden Bereichen ein gemeinsamer Teilbereich zugeordnet ist.

Bevorzugt ist jedem strahlungsemittierenden Bereich genau ein Teilbereich zugeordnet und jedem Teilbereich genau ein strahlungsemittierender Bereich. Das heißt, die strahlungsemittierenden Bereiche sind den konvex gekrümmten Teilbereichen eineindeutig zugeordnet. Beispielsweise sind die strahlungsemittierenden Bereiche dann zentriert zum eineindeutig zugeordneten konvex gekrümmten Teilbereich angeordnet.

Gemäß zumindest einer Ausführungsform bildet der konvex gekrümmte Teilbereich für zumindest einen Teil der im zugeordneten strahlungsemittierenden Bereich erzeugten elektromagnetischen Strahlung einen Konkavspiegel. Dies ist zum Beispiel dadurch realisiert, dass der konvex gekrümmte Teilbereich - wie weiter oben bereits beschrieben - zumindest stellenweise mit einer reflektierenden Schicht oder Schichtenfolge bedeckt ist. Das heißt beispielsweise, dass auf der dem Träger zugewandten Oberfläche des Halbleiterkörpers eine reflektierende Schicht oder Schichtenfolge vorgesehen ist. Die Form des Konkavspiegels ist durch die Form des konvex gekrümmten Teilbereichs bestimmt.

Gemäß zumindest einer Ausführungsform des optoelektronischen Chips ist der einem Teilbereich zugeordnete strahlungsemittierende Bereich zumindest stellenweise in der Brennebene dieses Konkavspiegels angeordnet. Das heißt, bevorzugt ist der strahlungsemittierende Bereich zumindest stellenweise im Brennpunkt des Konkavspiegels angeordnet. Das heißt, zumindest ein Teil des strahlungsemittierenden Bereichs befindet sich im Brennpunkt eines Konkavspiegels, der durch einen reflektierend beschichteten Teilbereich des Halbleiterkörpers gebildet ist.

Gemäß eines Beispiels weist zumindest einer der Teilbereiche zumindest stellenweise eine parabolische Krümmung auf. Bevorzugt bildet der reflektierend beschichtete Teilbereich dann einen Parabolspiegel für die im zugeordneten strahlungsemittierenden Bereich erzeugte elektromagnetische Strahlung.

Der Chip weist erfindungsgemäß eine sphärische Krümmung auf. Das heißt, er ist nach Art einer Kugel geformt.

Gemäß eines Beispiels weist zumindest einer der Teilbereiche eine asphärische Krümmung auf. Das heißt, der Teilbereich ist zumindest stellenweise asphärisch gekrümmt. Durch die Krümmung des Teilbereichs, können die optischen Eigenschaften des durch den Teilbereich gebildeten Konkavspiegels eingestellt werden.

Der beschriebene optoelektronische Chip macht sich dabei unter anderem die Idee zunutze, dass über die Krümmung des reflektierend ausgestalteten Teilbereichs die Abstrahlcharakteristik und die Abstrahlrichtung der vom optoelektronischen Chip erzeugten elektromagnetischen Strahlung gezielt einstellbar sind. So kann mittels der Krümmung des Teilbereichs beispielsweise erreicht sein, dass ein besonders großer Anteil der erzeugten elektromagnetischen Strahlung gezielt in einen bestimmten Raumwinkelbereich reflektiert wird. Dies erhöht vorteilhaft die Auskoppeleffizienz in diesem Raumbereich.

Gemäß zumindest einer Ausführungsform des optoelektronischen Chips weist die dem Träger abgewandte Oberfläche des Halbleiterkörpers zumindest einen Bereich auf, der derart strukturiert ist, dass er eine Linse für die im Betrieb des Chips vom strahlungsemittierenden Bereich erzeugte elektromagnetischer Strahlung bildet.

Dem strahlungsemittierenden Bereich ist gemäß zumindest einer Ausführungsform des optoelektronischen Chips eine Linse nachgeordnet. Unter Linse ist dabei beispielsweise ein optisches Element zu verstehen, das geeignet ist, elektromagnetische Strahlung, die durch das optische Element tritt, definiert zu brechen. Es ist aber auch möglich, dass die Linse geeignet ist, elektromagnetische Strahlung zu beugen. Ferner ist es möglich, dass die Linse sowohl zur Lichtbrechung als auch zur Lichtbeugung geeignet ist. Bevorzugt ist die Linse dem strahlungsemittierenden Bereich derart nachgeordnet, dass zumindest ein Teil der im strahlungsemittierenden Bereich erzeugten elektromagnetischen Strahlung durch die Linse tritt und von dieser gebrochen und/oder gebeugt werden kann. Der Linse kann darüber hinaus auch zur Verbesserung der Auskoppelwahrscheinlichkeit von elektromagnetischer Strahlung aus dem Chip vorgesehen sein. Durch die Formgebung der Linse und die Anordnung der Linse relativ zum strahlungsemittierenden Bereich kann vorteilhaft die Wahrscheinlichkeit für Totalreflexion bei Austritt von Strahlung aus dem Chip reduziert sein. Beispielsweise kann die Linse dazu die Form einer Halbkugel aufweisen, wobei sich der strahlungsemittierende Bereich im Mittelpunkt der Kugel befindet.

Die Linse ist bevorzugt durch zumindest einen Teilbereich des Halbleiterkörpers gebildet. Das heißt, zumindest ein Bereich des Halbleiterkörpers ist derart strukturiert, dass er geeignet ist, im strahlungsemittierenden Bereich erzeugte elektromagnetische Strahlung zu brechen und/oder zu beugen. Beispielsweise kann die Linse durch einen strukturierten Bereich der Oberfläche des Halbleiterkörpers gebildet sein.

Der strukturierte Bereich des Halbleiterkörpers kann beispielsweise eine definierte Krümmung aufweisen. Die Linse kann dann beispielsweise durch diesen Teil der Oberfläche begrenzt sein. Elektromagnetische Strahlung, die durch den gekrümmten Teilbereich der Oberfläche aus dem Halbleiterkörper tritt, wird dann zum Beispiel nach den Gesetzen der geometrischen Optik gebrochen.

Gemäß zumindest einer Ausführungsform des optoelektronischen Chips ist die laterale Ausdehnung der Linse größer als die laterale Ausdehnung des strahlungsemittierenden Bereichs. Unter lateraler Ausdehnung der Linse ist beispielsweise die maximale Erstreckung der Linse in einer Ebene senkrecht zur Wachstumsrichtung der epitaktischen Schichtenfolge zu verstehen. Bevorzugt ist die laterale Ausdehnung der Linse wenigstens doppelt so groß wie die laterale Ausdehnung des strahlungsemittierenden Bereichs. Besonders bevorzugt ist die laterale Ausdehnung der Linse wenigstens dreimal so groß wie die laterale Ausdehnung dieses Bereichs.

Gemäß zumindest einer Ausführungsform des optoelektronischen Chips ist jedem strahlungsemittierenden Bereich genau eine Linse zugeordnet. Die im strahlungsemittierenden Bereich erzeugte elektromagnetische Strahlung tritt dann zum überwiegenden Teil durch die dem Bereich zugeordnete Linse aus dem Chip aus. Kaum oder gar keine im strahlungsemittierenden Bereich erzeugte elektromagnetische Strahlung tritt in diesem Fall durch andere, beispielsweise benachbarte Linsen aus.

Gemäß zumindest einer Ausführungsform des optoelektronischen Chips ist jedem strahlungsemittierenden Bereich genau eine Linse und jeder Linse genau ein strahlungsemittierender Bereich zugeordnet. Das heißt, jedem strahlungsemittierenden Bereich ist bevorzugt eine Linse eineindeutig zugeordnet. Besonders bevorzugt sind der' strahlungsemittierende Bereich und die zugeordnete Linse zentriert zueinander angeordnet. Die Linse ist dann bevorzugt auch zentriert zum konvex gekrümmten Teilbereich des Halbleiterkörpers angeordnet, der dem strahlungsemittierenden Bereich eineindeutig zugeordnet ist. Das heißt, bevorzugt sind dann Linse, konvex zum Träger hin gekrümmter Teilbereich und strahlungsemittierender Bereich paarweise eineindeutig zueinander zugeordnet.

Gemäß zumindest einer Ausführungsform des optoelektronischen Chips ist die Linse mittels einer Ätztechnik in die Oberfläche des Halbleiterkörpers strukturiert, die dem Träger abgewandt ist. Der Halbleiterkörper bildet dann in diesem Bereich eine nach außen gewölbte Volumenlinse. Die Linse kann beispielsweise eine sphärische oder eine asphärische Krümmung aufweisen. Es ist aber auch möglich, dass es sich bei der Linse um eine Fresnel-Linse handelt.

Zumindest ein Teil des strahlungemittierenden Bereichs ist im Mittelpunkt einer Kugel aus Halbleitermaterial angeordnet, die durch Strukturierung der dem Träger zugewandten und der dem Träger abgewandten Oberfläche des Halbleiterkörpers gebildet ist. Dazu sind beispielsweise auf den beiden voneinander abgewandten Oberflächen des Halbleiterkörpers sphärisch gekrümmte, konvexe Bereiche ausgebildet, die sich zu einer Kugel ergänzen. Bevorzugt ist der dem Träger zugewandte konvex gekrümmte Teilbereich dabei reflektierend ausgestaltet, das heißt, der Teilbereich ist zumindest stellenweise reflektierend beschichtet. Bevorzugt sind die konvex gekrümmten Bereiche mittels Ätztechnik in den Halbleiterkörper strukturiert. Sowohl die dem Träger zugewandte, als auch die dem Träger abgewandte Oberfläche des Halbleiterkörpers weist dann gekrümmte, geätzte Strukturen auf.

Ein derart strukturierter Halbleiterchip macht sich dabei unter Anderem die Idee zu Nutzen im Inneren - vorzugsweise im Mittelpunkt - einer Kugel aus Halbleitermaterial eine Strahlungsquelle - den strahlungsemittierenden Bereich - anzuordnen. Bevorzugt gilt für die laterale Ausdehnung des strahlungsemittierenden Bereichs

$$r \; < \; R \; n_2/n_1,$$

wobei R den Radius der Kugel aus Halbleitermaterial bezeichnet, $n_2$ den Brechungsindex des Mediums, das an die Strahlungsaustrittsfläche des optoelektronischen Chips grenzt und $n_1$ den Brechungsindex des Materials, aus dem die Kugel bebildet ist.

Es wird ferner ein Verfahren zur Herstellung eines optoelektronischen Chips angegeben.

Zunächst wird ein Halbleiterkörper vorzugsweise epitaktisch auf ein Aufwachssubstrat abgeschieden. Bevorzugt umfasst der Halbleiterkörper zumindest eine aktive Zone, die durch eine Schicht oder Schichtenfolge des Halbleiterkörpers gebildet ist. Die aktive Zone weist beispielsweise einen pn-Übergang, eine Doppelheterostruktur, eine QuantentopfStruktur oder eine MehrfachquantentopfStruktur zur Erzeugung elektromagnetischer Strahlung auf.

Auf der dem Aufwachssubstrat zugewandten Seite und/oder der dem Aufwachssubstrat abgewandten Seite der aktiven Zone sind Füllschichten abgeschieden, in die nachfolgend konvex gekrümmte Bereiche strukturiert werden können.

Mittels Strukturierung der dem Substrat abgewandten Oberfläche des Halbleiterkörpers wird zumindest ein vom Substrat konvex weg gekrümmter Teilbereich erzeugt. Beispielsweise erfolgt die Strukturierung der Oberfläche mittels einer Ätztechnik in die dem Substrat abgewandte Füllschicht. Bevorzugt wird eine Vielzahl solcher Teilbereiche auf der Oberfläche des Halbleiterkörpers erzeugt.

Erfindungsgemäß werden strahlungsemittierende Bereiche in der aktiven Zone erzeugt, deren laterale Ausdehnung kleiner ist, als die laterale Ausdehnung der konvex gekrümmten Teilbereiche. Die strahlungsemittierenden Bereiche können beispielsweise durch eines der folgenden Verfahren erzeugt werden: Protonenimplantation, Quantenwellintermixing, Oxidation einer hochaluminiumhaltigen Schicht.

In einem weiteren Verfahrensschritt wird ein Träger auf die dem Substrat abgewandte Oberfläche des Halbleiterkörpers aufgebracht. Beispielsweise kann der Träger auf das Substrat gebondet werden. Das heißt, die konvex gekrümmten Teilbereiche auf der Oberfläche des Halbleiterkörpers sind dem Träger zugewandt.

Erfindungsgemäß umfasst das Verfahren zur Herstellung eines optoelektronischen Chips folgende Schritte:

- Abscheiden eines Halbleiterkörpers, umfassend eine aktive Zone auf einem Substrat, - Erzeugen zumindest eines vom Substrat konvex weg gekrümmten
  Teilbereichs mittels Strukturierung der dem Substrat abgewandten Oberfläche des Halbleiterkörpers,
- Erzeugen eines strahlungsemittierenden Bereichs in der aktiven Zone, dessen laterale Ausdehnung kleiner ist, als die laterale Ausdehnung des Teilbereichs und
- Aufbringen eines Trägers auf die dem Substrat abgewandte Oberfläche des Halbleiterkörpers.

Die aufgezeigte Reihenfolge der einzelnen Verfahrensschritte ist beim beschriebenen Verfahren nicht zwingend einzuhalten. Beispielsweise kann die Erzeugung der strahlungsemittierenden Bereiche auch nach dem Aufbringen eines Trägers auf die dem Substrat abgewandte Oberfläche des Halbleiterkörpers erfolgen.

Gemäß zumindest einer Ausführungsform des Verfahrens wird nach Aufbringen des Trägers das Substrat gedünnt. Das heißt, die Dicke des Substrats wird beispielsweise mittels einer der folgenden Techniken verringert: Ätzen, Sägen, Schleifen. Gemäß zumindest einer Ausführungsform wird das Substrat vollständig vom Halbleiterkörper entfernt. Beispielsweise erfolgt das Entfernen des Substrats mittels einer der folgenden Techniken: Ätzen, Sägen, Schleifen, Laserablation. Der Halbleiterkörper ist in diesem Fall frei von einem Aufwachssubstrat.

Erfindungsgemäß wird auf der dem Träger abgewandten Oberfläche des Halbleiterkörpers ein vom Träger konvex weg gekrümmter Bereich durch Strukturierung der Oberfläche des Halbleiterkörpers erzeugt. Die Strukturierung der Oberfläche erfolgt dabei beispielsweise mittels einer Ätztechnik. Der Bereich bildet bevorzugt eines der folgenden optischen Elemente: Sphärische Volumenlinse, asphärische Volumenlinse, Fresnel-Linse. Das heißt, es wird zumindest eine Linse auf der Oberfläche des Halbleiterkörpers erzeugt, die dem Träger abgewandt ist. Bevorzugt wird mittels des Verfahrens eine Vielzahl solcher Bereiche erzeugt. Bevorzugt ist jedem Bereich eineindeutig ein strahlungsemittierender Bereich in der aktiven Zone zugeordnet.

Gemäß zumindest einer Ausführungsform des Verfahrens werden strahlungsemittierende Bereiche in der aktiven Zone durch Schädigung zumindest eines Teils der aktiven Zone erzeugt. Das heißt, Teile der aktiven Zone werden derart geschädigt, dass sie zur Erzeugung von elektromagnetischer Strahlung nicht mehr geeignet sind. Nichtgeschädigte Bereiche der aktiven Zone bilden dann die strahlungsemittierenden Bereiche. Bevorzugt wird auf diese Weise eine Vielzahl strahlungsemittierender Bereiche erzeugt. Besonders bevorzugt ist jedem strahlungsemittierenden Bereich ein dem Träger zugewandter konvex gekrümmter Teilbereich eineindeutig zugeordnet.

Im Folgenden werden der hier beschriebene optoelektronische Chip sowie das hier beschriebene Verfahren anhand von Ausführungsbeispielen und den dazugehörigen Figuren näher erläutert.

Figur 1 zeigt eine schematische Schnittdarstellung eines ersten Beispieles des optoelektronischen Chips.

Figur 2A zeigt eine grafische Auftragung der Auskoppeleffizienz gegen den Radius der aktiven Zone für das erste Beispiel des optoelektronischen Chips.

Figur 2B zeigt eine grafische Auftragung der Auskoppeleffizienz gegen den Abstand des strahlungsemittierenden Bereichs von der Strahlungsaustrittsfläche für das erste Beispiel.

Figur 3 zeigt eine schematische Schnittdarstellung eines ersten Ausführungsbeispiels des optoelektronischen Chips.

Figur 4 zeigt eine grafische Auftragung der Auskoppeleffizienz gegen den Radius des strahlungsemittierenden Bereichs für das erste Ausführungsbeispiel des optoelektronischen Chips.

Figur 5A bis Figur 5H zeigen schematische Schnittdarstellungen von Verfahrensschritten zur Herstellung eines hier beschriebenen optoelektronischen Chips.

In den Ausführungsbeispielen und Figuren sind gleiche oder gleichwirkende Bestandteile jeweils mit den gleichen Bezugszeichen versehen. Die dargestellten Elemente der Figuren sind nicht als maßstabsgerecht anzusehen. Vielmehr können einzelne Elemente der Figuren zum besseren Verständnis teilweise übertrieben groß und nicht in tatsächlicher Größenrelation zueinander dargestellt sein.

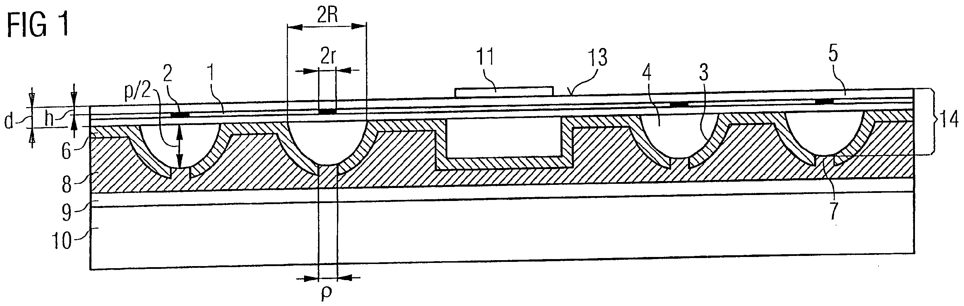

Figur 1 zeigt eine schematische Schnittdarstellung eines ersten Beispiels des hier beschriebenen optoelektronischen Chips.

In diesem Beispiel ist auf dem Träger 10 ein Halbleiterkörper 14 angeordnet, der beispielsweise eine Dünnfilmschicht umfasst. Der Träger 10 kann zum Beispiel ein Wafer sein. Beispielsweise kann der Träger wenigstens eines der folgenden Materialien enthalten: Germanium, Galliumarsenid, Galliumnitrid, Siliziumkarbid, Saphir, Molybdän, Metalle, Karbon.

Es ist auch möglich, dass der Träger durch eine flexible elektrisch leitende Folie gebildet ist. Beispielsweise kann der Träger durch eine Karbonfolie gegeben sein. Die Dicke der Folie ist dabei bevorzugt kleiner gleich 100 $\mu$m.

Der Träger ist bevorzugt mittels einer Bondschicht 9 mit dem Halbleiterkörper 14 mechanisch verbunden und elektrisch kontaktiert. Auf die dem Träger 10 zugewandte Oberfläche des Halbleiterkörpers 14 ist vorzugsweise eine elektrisch isolierende, dielektrische Schicht 6 aufgebracht. Die dielektrische Schicht 6 enthält beispielsweise eines der folgenden Materialien: ein Siliziumnitrid, ein Siliziumoxid, ein Aluminiumoxid. Bevorzugt besteht die dielektrische Schicht 6 aus $Si_3N_4$ oder SiN oder enthält diese Materialien.

Der dielektrischen Schicht 6 folgt eine reflektierende Metallschicht 8 nach, die beispielsweise ein reflektierendes Metall wie Gold, Silber, Goldgermanium, Aluminium oder Platin enthält. Die reflektierende Metallschicht 8 ist zwischen der dielektrischen Schicht 6 und dem Träger 10 angeordnet.

Die reflektierende Metallschicht 8 ist zum Einen bevorzugt besonders gut elektrisch leitend und zum Anderen geeignet, die im strahlungsemittierenden Bereichen 2 der aktiven Zone 1 des Halbleiterkörpers 14 erzeugte elektromagnetische Strahlung zumindest teilweise in Richtung der Oberfläche 13 des Halbleiterkörpers 14 zu reflektieren.

Die dielektrische Schicht 6 weist Durchbrüche auf, welche die Stromeinkoppelbereiche 7 bilden. Die Durchbrüche enthalten dabei bevorzugt das Material der reflektierenden Metallschicht 8, das in den Durchbrüchen direkt an den Halbleiterkörper 14 grenzt. Die Stromeinkoppelbereiche 7 weisen beispielsweise eine laterale Ausdehnung p auf. Sie können beispielsweise zylinderförmig ausgebildet sein. Die laterale Ausdehnung p ist dann durch den Durchmesser dieses Zylinders gegeben.

Der Halbleiterkörper 14 basiert beispielsweise

Chips.

auf Nitridverbindungshalbleitern, Phosphidverbindungshalbleitern oder Arsenidverbindungshalbleitern.

Auf Nitrid-Verbindungshalbleitern basierend bedeutet im vorliegenden Zusammenhang, dass zumindest eine Schicht der aktiven Epitaxie-Schichtenfolge - beispielsweise die aktive Zone 1 - ein Nitrid-III/V-Verbindungshalbleitermaterial, vorzugsweise $Al_nGa_mIn_{1-n-m}N$ umfasst, wobei $0 \leq n \leq 1$, $0 \leq m \leq 1$ und $n+m \leq 1$. Dabei muss dieses Material nicht zwingend eine mathematisch exakte Zusammensetzung nach obiger Formel aufweisen. Vielmehr kann das Material ein oder mehrere Dotierstoffe sowie zusätzliche Bestandteile aufweisen, die die charakteristischen physikalischen Eigenschaften des $Al_nGa_mIn_{1-n-m}N$-Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

Auf Phosphid -Verbindungshalbleitern basierend bedeutet im vorliegenden Zusammenhang, dass zumindest eine Schicht der aktiven Epitaxie-Schichtenfolge - beispielsweise die aktive Zone 1 - ein Phosphid-III/V-Verbindungshalbleitermaterial, vorzugsweise $Al_nGa_mIn_{1-n-m}P$ umfasst, wobei $0 \leq n \leq 1$, $0 \leq m \leq 1$ und $n+m \leq 1$. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die charakteristischen physikalischen Eigenschaften des $Al_nGa_mIn_{1-n-m}P$-Materials im Wesentlichen nicht ändern. Der Einfachheit halber beinhaltet obige Formel jedoch nur die wesentlichen Bestandteile des Kristallgitters (Al, Ga, In, P), auch wenn diese teilweise durch geringe Mengen weiterer Stoffe ersetzt sein können.

Auf Arsenid-Verbindungshalbleitern basierend bedeutet im vorliegenden Zusammenhang, dass zumindest eine Schicht der aktiven Epitaxie-Schichtenfolge - beispielsweise die aktive Zone 1 - ein Arsenid-III/V-Verbindungshalbleitermaterial, vorzugsweise $Al_nGa_mIn_{1-n-m}As$ umfasst, wobei $0 \leq n \leq 1$, $0 \leq m \leq 1$ und $n+m < 1$. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die charakteristischen physikalischen Eigenschaften des $Al_nGa_mIn_{1-n-m}As$-Materials im Wesentlichen nicht ändern. Der Einfachheit halber beinhaltet obige Formel jedoch nur die wesentlichen Bestandteile des Kristallgitters (Al, Ga, In, As), auch wenn diese teilweise durch geringe Mengen weiterer Stoffe ersetzt sein können.

Der Halbleiterkörper weist weiter bevorzugt wenigstens eine aktive Zone 1 auf, die zur Erzeugung elektromagnetischer Strahlung geeignet ist. Die aktive Zone 1 kann beispielsweise einen pn-Übergang, eine Doppelheterostruktur, eine EinfachquantentopfStruktur oder eine MehrfachquantentopfStruktur aufweisen.

Die Bezeichnung QuantentopfStruktur umfasst im Rahmen der Anmeldung jegliche Struktur, bei der Ladungsträger durch Einschluss ("Confinement") eine Quantisierung ihrer Energiezustände erfahren. Insbesondere beinhaltet die Bezeichnung QuantentopfStruktur keine Angabe über die Dimensionalität der Quantisierung. Sie umfasst somit unter anderem Quantentröge, Quantendrähte und Quantenpunkte und jede Kombination dieser Strukturen.

Die aktive Zone 1 weist strahlungsemittierende Bereiche 2 auf. Die strahlungsemittierenden Bereich 2 können durch Schädigung der aktiven Zone 1 in Bereichen erzeugt sein, in denen keine Strahlungserzeugung im Betrieb des optoelektronischen Chips stattfinden soll. Die Schädigung der aktiven Zone kann beispielsweise mittels Protonenimplantation, Oxidation einer hochaluminiumhaltigen Schicht oder Quantenwellintermixing erfolgen.

Weiter ist es möglich, dass die dem Träger zugewandte beispielsweise p-dotierte Seite des Halbleiterkörpers eine geringe Querleitfähigkeit aufweist, sodass bei Einkoppelung von Strom durch die Stromeinkoppelbereiche 7 im Wesentlichen Bereiche der aktiven Zone 1 bestromt werden, die eine senkrechte Projektion der Stromeinkoppelbereiche 7 in die Ebene der aktiven Zone 1 sind.

Die strahlungsemittierenden Bereiche 2 weisen bevorzugt eine laterale Ausdehnung 2r auf. Beispielsweise sind die strahlungsemittierenden Bereiche Zylinder- oder scheibenförmig, wobei der Durchmesser des Zylinders die laterale Ausdehnung des strahlungsemittierenden Bereichs ist. Die strahlungsemittierenden Bereiche weisen dann jeweils einen Radius r auf.

Weiter enthält der Halbleiterkörper 14 im Beispiel der Figur 1 konvex zum Träger 10 hin gekrümmte Teilbereiche 3. Die Teilbereiche 3 sind in die Füllschicht 4 des Halbleiterkörpers 14 beispielsweise mittels einer Ätztechnik strukturiert. Die Teilbereiche 3 sind zumindest stellenweise mit der dielektrischen Schicht 6 und der Metallschicht 8 reflektierend beschichtet.

Im Beispiel der Figur 1 sind die Teilbereiche 3 durch Paraboloide der Form $y^2 = 2pz$ gegeben, wobei z die Schnittnormale ist und y in einer Ebene liegt, die parallel zur Oberfläche des Trägers 10 verläuft, auf die der Halbleiterkörper 14 aufgebracht ist. Die reflektierend beschichteten Teilbereiche 3 wirken im Beispiel der Figur 1 für die im strahlungsemittierenden Bereich 2 erzeugte elektromagnetische Strahlung im Sinne von Parabolspiegeln.

Bevorzugt ist jedem strahlungsemittierenden Bereich 2 ein Teilbereich 3 eineindeutig zugeordnet. Besonders bevorzugt liegt jeder strahlungsemittierende Bereich 2 zumindest stellenweise in der Brennebene eines zugeordneten Parabolspiegels. Das heißt, zumindest Teile des strahlungsemittierenden Bereichs 2 liegen im Brennpunkt des Parabolspiegels. Im Betrieb des optoelektronischen Chips wird im strahlungsemittierenden Bereich 2 erzeugte elektromagnetische Strahlung vom zugeordneten Parabolspiegel reflektiert.

Auf der dem Träger abgewandten Seite der aktiven Zone 1 befindet sich zum Beispiel eine n-leitende Schicht 5, die als Stromaufweitungsschicht vorgesehen sein kann. Auf der Oberfläche 13 des optoelektronischen Chips ist ein Bondpad 11 aufgebracht. Bevorzugt ist die Schicht 5 geeignet, den über das Bondpad 11 eingekoppelten Strom gleichmäßig über die Oberfläche 13 des optoelektronischen Chips zu verteilen.

Alternativ dazu kann auf die Halbleiterschicht 5 verzichtet werden. Die Stromverteilung vom Bondpad 11 kann dann durch eine TCO-Schicht (Transparent Conductive Oxyd), die beispielsweise ein ITO (Indium Tin Oxyd) oder eine ZnO (Zinkoxid) enthalten kann, realisiert sein. Über dem strahlungsemittierenden Bereich, das heißt über dem Brennpunkt des Parabolspiegels, sind dann Kontaktpunkte angeordnet.

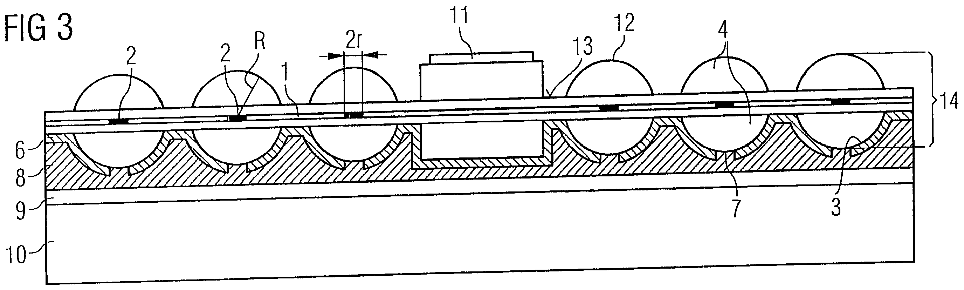

Weiter ist es möglich, dass den strahlungsemittierenden Bereichen 2 je eine Linse 12 (vergleiche dazu auch Figur 3) nachgeordnet ist, die beispielsweise zum strahlungsemittierenden Bereich zentriert angeordnet ist. Bei der Linse kann es sich um eine der folgenden Linsen handeln: sphärische Linse, asphärische Linse, Fresnel-Linse. Die Linse kann beispielsweise in eine Füllschicht 4 des Halbleiterkörpers 14 strukturiert sein, die sich auf der dem Träger 10 abgewandten Seite der aktiven Zone 1 befindet.

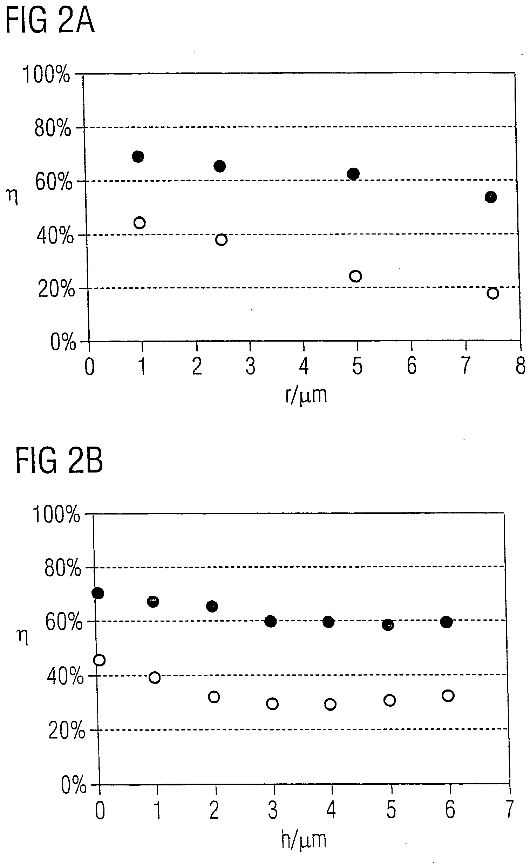

Figur 2A zeigt berechnete Werte der Auskoppeleffizienz $\mu$ in Prozent für ein Beispiel des optoelektronischen Chips, wie es in Figur 1 gezeigt ist. Folgende Modellparameter sind dabei konstant gehalten: Die Höhe des Paraboloids über der aktiven Zone 1 beträgt p/2 = 8 $\mu m$. Die aktive Zone liegt zumindest stellenweise in der Brennebene des Paraboloids. Der strahlungsemittierende Bereich 2 liegt zumindest stellenweise im Brennpunkt des Paraboloids. Die laterale Ausdehnung des Parboloids 2R beträgt cirka 4,5 $\mu m$. Die Dicke d der verbindenden Halbleiterschicht beträgt 2,2 $\mu m$, wobei die Dicke der aktiven Zone 1 0,2 $\mu m$ beträgt. Die aktive Zone 2 weist einen internen Wirkungsgrad für Photonenrecycling von 90 Prozent auf und ist im oben definierten AlGaInP-Halbleitersystem gebildet. Die Emissionswellenlänge beträgt 650 Nanometer.

Der Brechungsindex des Halbleiterkörpers im Materialsystem AlGaAs/AlGaInP beträgt circa zwischen 3,0 bis 3,5. Das heißt, die Füllschichten 4 sind im AlGaAs Materialsystem gebildet. Der Brechungsindex des den Chip umgebenden Materials beträgt 1,5. Dies entspricht beispielsweise dem Brechungsindex von Epoxidharz, das als Chipverguss an die Oberfläche 13 des optoelektronischen Chips grenzen kann.

Die dielektrische Schicht 6 besteht in diesem Beispiel aus einem Siliziumnitrid. Die Metallschicht 8 besteht aus Gold.

Figur 2A zeigt die Auskoppeleffizienz $\mu$ integral (gefüllte Kreise) und in die numerische Apertur gleich 0,5 (offene Kreise) in Abhängigkeit vom Radius r des strahlungsemittierenden Bereichs 2.

Wie Figur 2A zu entnehmen ist, ist die Auskoppeleffizienz in eine numerische Apertur gleich 0,5 umso größer, je enger der strahlungsemittierende Bereich 2 eingeschnürt ist. Für einen Radius des strahlungsemittierenden Bereichs 2 von r cirka 1 $\mu m$, das heißt für eine laterale Ausdehnung von circa 2 $\mu m$, wird eine Auskoppeleffizienz von über 40 Prozent in eine numerische Apertur gleich 0,5 erreicht.

Figur 2B zeigt die Auskoppeleffizienz in Abhängigkeit von der Dicke h der Halbleiterschicht 5. Die Dicke d der verbindenden Halbleiterschicht beträgt 1,2 $\mu m$ plus h. Der Radius r des strahlungsemittierenden Bereichs 2 ist auf 2,5 $\mu m$ festgehalten, die laterale Ausdehnung des strahlungsemittierenden Bereichs 2 beträgt damit 5 $\mu m$.

Wie Figur 2B zu entnehmen ist, steigt sowohl die integrale Auskoppeleffizienz (gefüllte Kreise) als auch die Auskoppeleffizienz in eine numerische Apertur 0,5 (offene Kreise) mit verringerter Dicke h der Halbleiterschicht 5 an. Dies ist darauf zurückzuführen, dass nach vorne emittierte Strahlen, die nicht innerhalb des Auskoppelkegels liegen - die also an der Oberfläche 13 des optoelektronischen Chips totalreflektiert werden - bei einer geringeren Dicke h sehr nahe am strahlungsemittierenden Bereich reflektiert werden. Das derart erzeugte virtuelle Bild des strahlungsemittierenden Bereichs 2 ist noch ausreichend nahe am Brennpunkt des durch den Teilbereich 3 gebildeten Parabolspiegels angeordnet, um diesen effizient nutzen zu können.

Ein bevorzugtes Ausführungsbeispiel des optoelektronischen Chips verzichtet daher auf die Halbleiterschicht 5. Die Stromaufweitung vom Bondpad 11 kann in diesem Fall durch eine TCO-Schicht und Kontaktpunkte über den Zentren des Paraboloids realisiert sein.

Die Figur 3 zeigt ein erstes Ausführungsbeispiel des hier beschriebenen optoelektronischen Chips.

Im Unterschied zum Beispiel der Figur 1 sind die konvex zum Träger 10 hin gekrümmten Teilbereiche 3 in diesem Ausführungsbeispiel sphärisch gekrümmt. Bevorzugt haben die Teilbereiche 3 die Form von Halbkugeln. Ferner sind in die dem Träger 10 abgewandte Oberfläche 13 des optoelektronischen Chips sphärische Linsen 12 in die Füllschicht 4 strukturiert.

Die strahlungsemittierende Bereich 2 sind auf diese Weise jeweils in Kugeln mit Radius R, die aus Halbleitermaterial bestehen, eingebettet.

Der derart gebildete optoelektronische Chip macht sich das Prinzip der Weierstrass-Kugel zu nutze. Im Inneren der durch den konvex gekrümmten Teilbereich 3 und die sphärische Linse 12 gebildeten Kugel mit einem Brechungsindex $n_1$ und einem Radius R ist der strahlungsemittierende Bereich 2 als Lichtquelle mit einer lateralen Ausdehnung 2r angeordnet. Für einen scheibenförmigen strahlungsemittierenden Bereich 2 mit einem Radius r ergibt sich für

$$r < R\ n_2/n_1,$$

wobei $n_2$ der Brechungsindex des umgebenden Mediums ist, eine besonders effiziente Auskopplung von der im strahlungsemittierenden Bereich 2 erzeugten elektromagnetischen Strahlung.

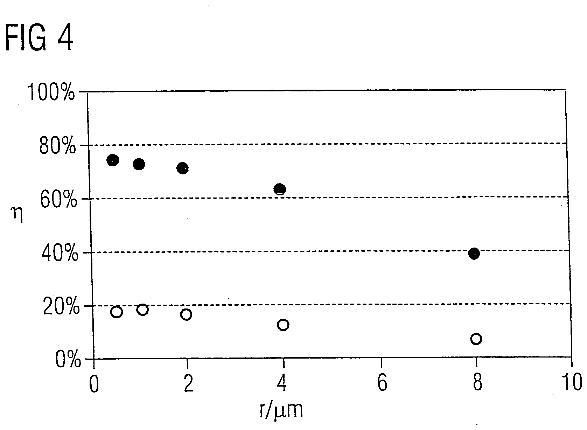

Figur 4 zeigt berechnete Werte der Auskoppeleffizienz $\mu$ als Funktion des Radius r des strahlungsemittierenden Bereichs 2 für einen optoelektronischen Chip wie er im Ausführungsbeispiel der Figur 3 beschrieben ist. Folgende Modellparameter sind dabei konstant gehalten:
Der Radius der durch konvex gekrümmte Bereiche 3 und Linse 12 gebildeten Halbleiterkugel beträgt R = 8 $\mu m$.

Die Dicke d der verbindenden Halbleiterschicht beträgt 2,2 $\mu$m, wobei die Dicke der aktiven Zone 1 0,2 $\mu$m beträgt. Die aktive Zone 1 weist einen internen Wirkungsgrad für Photonenrecycling von 90 Prozent auf und ist im oben definierten AlGaInP-Halbleitersystem gebildet. Die Emissionswellenlänge beträgt 650 Nanometer.

Der Brechungsindex des Halbleiterkörpers im Materialsystem AlGaAs/AlGaInP beträgt circa zwischen 3,0 bis 3, 5. Das heißt, die Füllschichten 4 sind im AlGaAs Materialsystem gebildet.

Der Brechungsindex des den Chip umgebenden Materials beträgt 1,5. Dies entspricht beispielsweise dem Brechungsindex von Epoxydharz, das beispielsweise als Chipverguss an die Oberfläche 13 des optoelektronischen Chips grenzen kann.

Die dielektrische Schicht 6 besteht in diesem Ausführungsbeispiel aus einem Siliziumnitrid. Die Metallschicht 8 besteht aus Gold.

Bei einem Kugelradius von R = 8 $\mu$m bedeutet die oben genannte Weierstrass-Bedingung, dass der Radius des strahlungsemittierenden Bereichs auf höchstens 3, 5 $\mu$m eingeschränkt werden sollte.

Wie Figur 4 zu entnehmen ist, wird die Auskoppeleffizienz umso größer, je kleiner der strahlungsemittierende Bereich gewählt wird. Bei einer Einschränkung des Radius r des strahlungsemittierenden Bereichs 2 auf 2 $\mu$m, das heißt bei einer lateralen Ausdehnung des strahlungsemittierenden Bereichs 2 von 4 $\mu$m, kann beispielsweise eine integrale Auskoppeleffizienz von circa 75 Prozent erreicht werden.

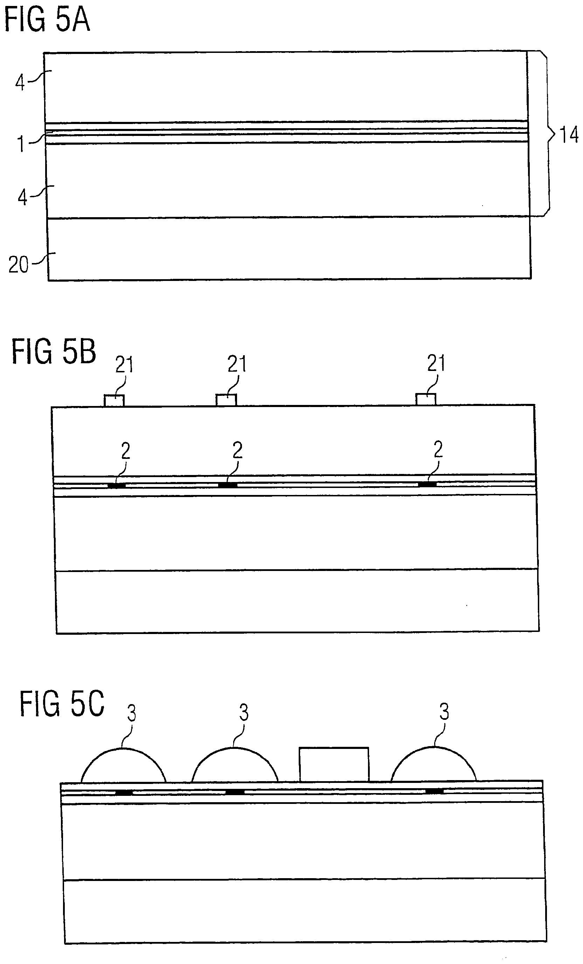

Die Herstellung des optoelektronischen Chips, wie er beispielsweise in Figur 3 gezeigt ist, kann wie folgt erfolgen: Zunächst wird ein Halbleiterkörper 14 umfassend Füllschichten 4 und aktive Zone 1 auf einen Aufwachssubstratwafer (20) epitaktisch abgeschieden (siehe dazu Figur 5A).

Figur 5B zeigt wie nachfolgend eine Maske auf die dem Substrat 20 abgewandte Oberfläche des Halbleiterkörpers 14 aufgebracht wird, die Bereiche definiert, die zur Strahlungserzeugung geeignet sein sollen. Nicht durch die Maske geschützte Bereiche werden beispielsweise mittels Protonenimplantation geschädigt, wodurch strahlungserzeugende Bereiche 2 in der aktiven Zone 1 definiert werden.

In einem folgenden Verfahrensschritt (Figur 5C) werden die später dem Träger 10 zugewandten Teilbereiche 3 mittels Ätzen erzeugt. Dies erfolgt beispielsweise unter Verwendung von durch einen Temperschritt verrundeten Fotolack und nachfolgendem Trockenätzen.

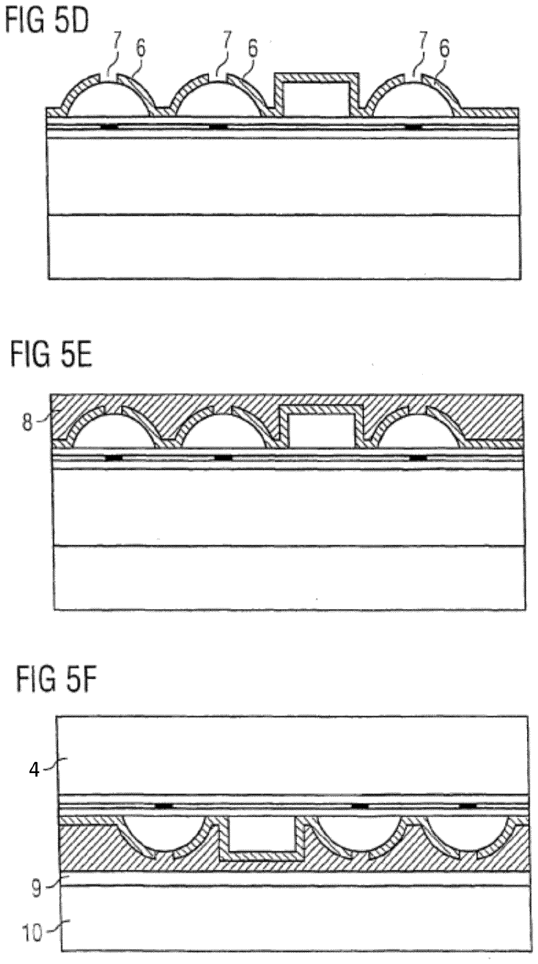

Figur 5D zeigt, wie nachfolgend eine dielektrische Schicht 6, die zum Beispiel ein Siliziumnitrid enthalten kann, auf die Teilbereiche 3 aufgebracht wird. Oberhalb der strahlungsemittierenden Bereiche 2 wird die dielektrische Schicht beispielsweise mittels Ätzen geöffnet, um Stromeinkoppelbereich 7 für eine spätere Strominjektion zu erzeugen.

In einem weiteren Verfahrensschritt (siehe Figur 5E) wird eine Spiegel- und Kontaktmetallisierung - die Metallschicht 8 - die beispielsweise Gold enthält, aufgebracht.

Mittels zum Beispiel einer Waferbondtechnik wird ein Träger 10 mit Hilfe der Bondschicht 9 auf die dem Aufwachssubstrat 20 abgewandte Oberfläche des Halbleiterkörpers 14 aufgebracht und das Aufwachssubstrat 20 nachfolgend entfernt (siehe Figur 5F).

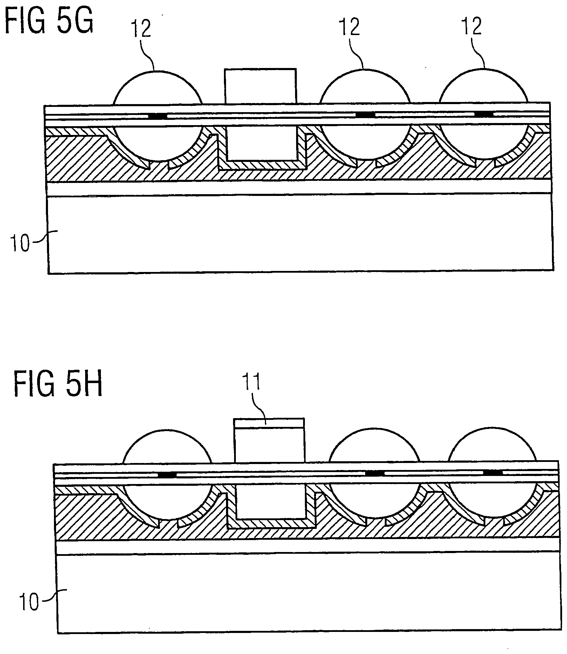

Figur 5G zeigt wie nachfolgend analog zum Erzeugen der Teilbereiche 3 sphärische Strukturen - die Linsen 12 - in die vom Träger 10 abgewandte Füllschicht 4 beispielsweise mittels einer Trockenätztechnik strukturiert werden.

Figur 5H zeigt das Aufbringen eines Bondpads 11.

Zur Stromverteilung kann es weiter nötig sein, ein Kontaktgitter oder durch ein TCO verbundene Kontaktpunkte auf der Oberseite 13 des Halbleiterkörpers 14 aufzubringen. Bevorzugt befinden sich die metallischen - und damit elektromagnetische Strahlung abschirmende - Kontaktbereiche in Gräben zwischen den die Linsen 12 bildenden Halbkugeln auf der dem Träger 10 abgewandte Oberfläche 13 des Halbleiterkörpers 14.

In einem abschließenden, nicht gezeigten Verfahrensschritt werden Kontakte legiert und der Wafer in einzelne Chips segmentiert. Bevorzugt umfasst jeder optoelektronische Chip wenigstens 80 strahlungsemittierende Bereiche 2.

Alternativ kann beim beschriebenen Verfahren die Erzeugung der strahlungsemittierenden Bereiche 2 auch nach dem Ablösen des Aufwachssubstrats 20 erfolgen. Außerdem können neben der Protonenimplantation auch andere Techniken wie Oxidation einer hochaluminiumhaltigen AlGaAs-Schicht oder Quantenwellintermixing zur Erzeugung der strahlungsemittierenden Bereich 2 Verwendung finden.

Sind - wie beispielsweise im Beispiel der Figur 1 - keine Linsen 12 auf der dem Träger 10 abgewandten Oberfläche 13 des Halbleiterkörper 14 ausgebildet, so kann die Erzeugung strahlungsemittierender Bereiche 2 alternativ entfallen. Es findet dann zum Beispiel eine Halbleiterschicht 5 Verwendung, die eine genügend schlechte laterale Stromleitung aufweist. Das heißt, die Leitfähigkeit der Schicht 5 ist in einer Ebene parallel zur Oberfläche des Trägers 10, die dem Halbleiterkörper 14 zugewandt ist, stark eingeschränkt. In diesem Fall können über den Paraboloiden erzeugte Kontaktpunkte Verwendung finden. Aufgrund der geringen Stromaufweitung in der Schicht 5 entstehen so strahlungsemittierende Bereiche 2 in der aktiven Zone 1 deren laterale Ausdehnung ungefähr der lateralen Ausdehnung der Kontaktpunkte entspricht. Die strahlungsemittierenden Bereiche 2 sind dann in etwa eine senkrechte Projektion der Kontaktpunkte in die Ebene der aktiven Zone 1.

Diese Patentanmeldung beansprucht die Priorität der deutschen Patentanmeldung 102005033005.3-33, deren Offenbarungsgehalt hiermit durch Rückbezug aufgenommen wird.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen, in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Optoelektronischer Chip, aufweisend

   - einen Halbleiterkörper (14) mit einem strahlungsemittierenden Bereich (2), und
   - einem Teilbereich (3), in dem die Oberfläche (13) des Halbleiterkörpers (14) konvex zu einem Träger (10) hin gekrümmt ist, wobei
   - die laterale Ausdehnung (2r) des strahlungsemittierenden Bereichs (2) kleiner ist als die laterale Ausdehnung (2R) des Teilbereichs (3), **dadurch gekennzeichnet, dass**
   - zumindest ein Teil des strahlungsemittierenden Bereichs (2) im Mittelpunkt einer Kugel aus dem Halbleitermaterial des Halbleiterkörpers (14) angeordnet ist.

2. Optoelektronischer Chip nach Anspruch 1, bei dem zwischen Halbleiterkörper (14) und Träger (10) zumindest eine reflektierende Schicht (8) angeordnet ist.

3. Optoelektronischer Chip nach einem der Ansprüche 1 oder 2, bei dem die reflektierende Schicht (8) den Teilbereich (3) zumindest stellenweise bedeckt.

4. Optoelektronischer Chip nach einem der Ansprüche 1 bis 3, bei dem der Halbleiterkörper (14) eine Vielzahl strahlungsemittierender Bereiche (2) aufweist.

5. Optoelektronischer Chip nach einem der Ansprüche 1 bis 4, bei dem jedem strahlungsemittierenden Bereich (2) ein Teilbereich (3) zugeordnet ist.

6. Optoelektronischer Chip nach einem der Ansprüche 1 bis 5, bei dem jedem strahlungsemittierenden Bereich (2) ein Teilbereich (3) eineindeutig zugeordnet ist.

7. Optoelektronischer Chip nach einem der Ansprüche 1 bis 6, bei dem der Teilbereich (3) einen Konkavspiegel für die vom strahlungsemittierenden Bereich (2) erzeugte elektromagnetische Strahlung bildet.

8. Optoelektronischer Chip nach Anspruch 7, bei dem der strahlungsemittierende Bereich (2) zumindest stellenweise in der Brennebene des Konkavspiegels angeordnet ist.

9. Optoelektronischer Chip nach einem der Ansprüche 1 bis 8, bei dem die dem Träger (10) abgewandte Oberfläche (13) des Halbleiterkörpers (14) einen Bereich (12) aufweist, der derart strukturiert ist, dass er eine Linse (12) für die vom strahlungsemittierenden Bereich (2) erzeugte elektromagnetische Strahlung bildet, wobei die Linse (12) durch einen vom Träger konvex weg gekrümmten Bereich der Oberfläche (13) des Halbleiterkörpers (14) gebildet ist.

10. Optoelektronischer Chip nach Anspruch 9, bei dem die laterale Ausdehnung (2r) des strahlungsemittierenden Bereichs (2) kleiner ist als die laterale Ausdehnung (2R) der Linse (12).

11. Optoelektronischer Chip nach einem der Ansprüche 9 oder 10, bei dem jedem strahlungsemittierenden Bereich (2) genau eine Linse (12) zugeordnet ist.

12. Optoelektronischer Chip nach einem der Ansprüche 9 bis 11, dem jedem strahlungsemittierenden Bereich (2) eine Linse (12) eineindeutig zugeordnet ist.

13. Optoelektronischer Chip nach einem der Ansprüche 1 bis 12, bei dem die Dicke des Halbleiterkörpers (14) an ihrer dünnsten Stelle maximal 10 $\mu$m beträgt.

14. Verfahren zur Herstellung eines optoelektronischen Chips, umfassend die folgenden Schritte in der folgenden Reihenfolge:

    - Abscheiden eines Halbleiterkörpers (14), umfassend eine aktive Zone (1) auf einem Substrat (20),
    - Erzeugen eines strahlungsemittierenden Bereichs (2) in der aktiven Zone (1) dessen laterale Ausdehnung (2r) kleiner ist, als die laterale Ausdehnung (2R) eines vom Substrat (20) konvex weg gekrümmten Teilbereichs (3),
    - Erzeugen des vom Substrat konvex weg gekrümmten Teilbereichs (3) mittels Strukturierung der dem Substrat (20) abgewandten Oberfläche des Halbleiterkörpers (14), und

- Aufbringen eines Trägers auf die dem Substrat abgewandte Oberfläche des Halbleiterkörpers (14), wobei
- zumindest ein Teil des strahlungsemittierenden Bereichs (2) im Mittelpunkt einer Kugel aus Halbleitermaterial angeordnet ist, die durch die Strukturierung der dem Träger (10) zugewandten und der dem Träger (10) abgewandten Oberfläche des Halbleiterkörpers (14) gebildet ist.

**15.** Verfahren nach Anspruch 14, wobei das Substrat (20) gedünnt wird.

**16.** Verfahren nach Anspruch 14, wobei das Substrat (20) entfernt wird.

**17.** Verfahren nach einem der Ansprüche 14 bis 16, wobei auf der dem Träger (10) abgewandten Oberfläche (13) des Halbleiterkörpers (14) ein vom Träger konvex weg gekrümmter Bereich (12) durch Strukturierung der Oberfläche (13) erzeugt wird.

**18.** Verfahren nach einem der Ansprüche 14 bis 17, wobei der strahlungsemittierende Bereich (2) durch Schädigung zumindest eines Teils der aktiven Zone (1) strukturiert wird.

**Claims**

**1.** Optoelectronic chip having

- a semiconductor body (14) with a radiation-emitting region (2), and
- a partial region (3), in which the surface (13) of the semiconductor body (14) is curved convexly towards a carrier (10),
- the lateral extent (2r) of the radiation-emitting region (2) is smaller than the lateral extent (2R) of the partial region (3), **characterized in that**
- at least a part of the radiation-emitting region (2) is arranged in the center of a sphere of the semiconductor material of the semiconductor body (14).

**2.** Optoelectronic chip according to claim 1, in which at least one reflective layer (8) is arranged between the semiconductor body (14) and the carrier (10).

**3.** Optoelectronic chip according to one of claims 1 or 2, in which the reflective layer (8) covers the partial region (3) at least in places.

**4.** Optoelectronic chip according to one of claims 1 to 3,

in which the semiconductor body (14) has a multiplicity of radiation-emitting regions (2).

**5.** Optoelectronic chip according to one of claims 1 to 4, in which a partial region (3) is assigned to each radiation-emitting region (2).

**6.** Optoelectronic chip according to one of claims 1 to 5, in which a partial region (3) is assigned one-to-one to each radiation-emitting region (2).

**7.** Optoelectronic chip according to one of claims 1 to 6, in which the partial region (3) forms a concave mirror for the electromagnetic radiation generated by the radiation-emitting region (2).

**8.** Optoelectronic chip according to claim 7, in which the radiation-emitting region (2) is arranged, at least in places, in the focal plane of the concave mirror.

**9.** Optoelectronic chip according to one of claims 1 to 8, in which the surface (13) of the semiconductor body (14) facing away from the carrier (10) has a region (12), which is patterned in such a way that it forms a lens (12) for the electromagnetic radiation generated by the radiation-emitting region (2), wherein the lens (12) is formed by a region of the surface (13) of the semiconductor body (14) that is curved convexly away from the carrier.

**10.** Optoelectronic chip according to claim 9, in which the lateral extent (2r) of the radiation-emitting region (2) is less than the lateral extent (2R) of the lens (12).

**11.** Optoelectronic chip according to one of claims 9 or 10, in which precisely one lens (12) is assigned to each radiation-emitting region (2).

**12.** Optoelectronic chip according to one of claims 9 to 11, in which a lens (12) is assigned one-to-one to each radiation-emitting region (2).

**13.** Optoelectronic chip according to one of claims 1 to 12, in which the thickness of the semiconductor body (14) is at most 10 $\mu$m at its thinnest location.

**14.** Method for producing an optoelectronic chip, comprising the following steps in the following order:

- depositing a semiconductor body (14) comprising an active zone (1) on a substrate (20),
- producing a radiation-emitting region (2) in the active zone (1), the lateral extent (2r) of the radiation-emitting region being less than the lateral extent (2R) of the partial region (3),
- producing the partial region (3) that is curved convexly away from the substrate by means of patterning the surface of the semiconductor body (14) facing away from the substrate (20), and
- applying a carrier to the surface of the semiconductor body (14) facing away from the substrate, wherein
- at least a part of the radiation-emitting region (2) is arranged in the centre of a sphere of semiconductor material, which is formed by the structuring of the surface of the semiconductor body (14) facing the carrier (10) and facing away from the carrier (10).

15. Method according to claim 14,
wherein the substrate (20) is thinned.

16. Method according to claim 14,
wherein the substrate (20) is removed.

17. Method according to one of claims 14 to 16,
wherein a region (12) that is curved convexly away from the carrier is produced on the surface (13) of the semiconductor body (14) facing away from the carrier (10), by patterning the surface (13).

18. Method according to one of claims 14 to 17,
Wherein the radiation-emitting region (2) is patterned by damaging at least one part of the active zone (1).


**Revendications**

1. Puce optoélectronique, comportant

- un corps semi-conducteur (14) avec une zone émettrice de rayonnement (2), et
- une zone partielle (3) dans laquelle la surface (13) du corps semi-conducteur (14) courbée convexe vers un support (10),
- l'étendue latérale (2r) de la zone émettrice de rayonnement (2) étant inférieure à l'étendue latérale (2R) de la zone partielle (3), **caractérisée en ce qu'**
- au moins une partie de la zone émettrice de rayonnement (2) est disposée au centre d'une sphère du matériau semi-conducteur du corps semi-conducteur (14).

2. Puce optoélectronique selon la revendication 1,
dans laquelle au moins une couche réfléchissante (8) est disposée entre le corps semi-conducteur (14) et le support (10).

3. Puce optoélectronique selon l'une des revendications 1 ou 2,
dans laquelle la couche réfléchissante (8) recouvre au moins par endroits la zone partielle (3).

4. Puce optoélectronique selon l'une des revendications 1 à 3,
dans laquelle le corps semi-conducteur (14) présente une pluralité de zones émettrices de rayonnement (2).

5. Puce optoélectronique selon l'une des revendications 1 à 4,
dans laquelle une zone partielle (3) est attribuée à chaque zone émettrice de rayonnement (2).

6. Puce optoélectronique selon l'une des revendications 1 à 5,
dans laquelle une zone partielle (3) est attribuée de manière biunivoque à chaque zone émettrice de rayonnement (2).

7. Puce optoélectronique selon l'une des revendications 1 à 6,
dans laquelle la zone partielle (3) constitue un miroir concave pour le rayonnement électromagnétique généré par la zone émettrice de rayonnement (2).

8. Puce optoélectronique selon la revendication 7,
dans laquelle la zone émettrice de rayonnement (2) est disposée au moins par endroits dans le plan focal du miroir concave.

9. Puce optoélectronique selon l'une des revendications 1 à 8,
dans laquelle la surface (13) du corps semi-conducteur (14) détournée du support (10) comporte une zone (12) structurée de telle sorte qu'elle constitue une lentille (12) pour le rayonnement électromagnétique généré par la zone émettrice de rayonnement (2), la lentille étant constituée par une zone de la surface (13) du corps semi-conducteur (14) à courbure convexe s'éloignant du support.

10. Puce optoélectronique selon la revendication 9,
dans laquelle l'étendue latérale (2r) de la zone émettrice de rayonnement (2) est inférieure à l'étendue latérale (2R) de la lentille (12).

11. Puce optoélectronique selon l'une des revendications 9 ou 10,
dans laquelle une lentille (12) juste est attribuée à chaque zone émettrice de rayonnement (2).

12. Puce optoélectronique selon l'une des revendications 9 à 11,
dans laquelle une lentille (12) est attribuée à chaque zone émettrice de rayonnement (2) de manière biunivoque.

13. Puce optoélectronique selon l'une des revendications 1 à 12,
dans laquelle l'épaisseur du corps semi-conducteur (14) à l'endroit le moins épais est de 10 μm au maximum.

14. Procédé de fabrication d'une puce optoélectronique comprenant les étapes suivantes dans l'ordre suivant :

- dépôt d'un corps semi-conducteur (14) comprenant une zone active (1) sur un substrat (20),
- génération d'une zone émettrice de rayonnement (2) dans la zone active (1) dont l'étendue latérale (2r) est inférieure à l'étendue latérale (2R) d'une zone partielle (3) à courbure convexe s'éloignant du substrat,
- génération de la zone partielle (3) courbée de manière convexe s'éloignant du substrat en structurant la surface du corps semi-conducteur (14) détournée du substrat (20),
et
- pose d'un support sur la surface du corps semi-conducteur (14) détournée du substrat,
- au moins une partie de la zone émettrice de rayonnement (2) étant disposée au centre d'une sphère constituée par du matériau semi-conducteur constituée par la structuration de la surface disposée en regard du support (10) et celle détournée du support (10).

15. Procédé selon la revendication 14,
dans lequel le substrat (20) est aminci.

16. Procédé selon la revendication 14,
dans lequel le substrat (20) est éliminé.

17. Procédé selon l'une des revendications 14 à 16,
dans lequel on génère sur la surface (13) du corps semi-conducteur (14) détournée du support (10) une courbure convexe s'éloignant du support, par structuration de la surface (13).

18. Procédé selon l'une des revendications 14 à 17,
dans lequel la zone émettrice de rayonnement (2) est structurée par lésion d'au moins une parte de la zone active (1).

FIG 1

## FIG 2A

## FIG 2B

FIG 3

EP 1 744 375 B1

# FIG 4

FIG 5A

FIG 5B

FIG 5C

# FIG 5D

# FIG 5E

# FIG 5F

FIG 5G

12          12          12

10

FIG 5H

11

10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 0213281 A1
- JP 55162284 A
- US 20050056856 A
- DE 2543471 A
- DE 102005033005333